# EUROPÄISCHE PATENTSCHRIFT

(11) **EP 1 231 645 B1**
(45) Veröffentlichungstag und Bekanntmachung des Hinweises auf die Patenterteilung: **30.08.2006**
(21) Anmeldenummer: 01129043.4
(22) Anmeldetag: 07.12.2001
(51) Int. Cl.: H01L 29/786, H01L 27/12

(54) **Laterales Halbleiterbauelement in Dünnfilm-SOI-Technik**
Thin film SOI semiconductor device
Dispositif semiconducteur SOI à couche mince

(30) Priorität: 12.02.2001 DE 10106359
(43) Veröffentlichungstag der Anmeldung: 14.08.2002
(73) Patentinhaber: Infineon Technologies AG, 81669 München (DE)
(72) Erfinder: Priefert, Dirk, 47445 Moers (DE); Rudolf, Ralf, 47057 Duisburg (DE); Boguszewicz, Viktor, 45279 Essen (DE); Michalzik, Frank, 46499 Hamminkeln/Mehrhoog (DE); Buckhorst, Rolf, 45475 Mülheim a. d. Ruhr (DE)
(74) Vertreter: TER MEER - STEINMEISTER & PARTNER GbR

(56) Entgegenhaltungen:
- EP-A- 0 694 977
- US-A- 5 760 442
- PATENT ABSTRACTS OF JAPAN Bd. 0111, Nr. 71 (E-512), 2. Juni 1987 (1987-06-02) -& JP 62 005662 A (NEC CORP), 12. Januar 1987 (1987-01-12)
- EMIL ARNOLD: "SILICON-ON-INSULATOR DEVICES FOR HIGH VOLTAGE AND POWER IC APPLICATIONS" JOURNAL OF THE ELECTROCHEMICAL SOCIETY, ELECTROCHEMICAL SOCIETY. MANCHESTER, NEW HAMPSHIRE, US, Bd. 141, Nr. 7, 1. Juli 1994 (1994-07-01), Seiten 1983-1988, XP000469380 ISSN: 0013-4651
- LU Q ET AL: "High voltage silicon-on-insulator (SOI) MOSFETs" POWER SEMICONDUCTOR DEVICES AND ICS, 1991. ISPSD '91., PROCEEDINGS OF THE 3RD INTERNATIONAL SYMPOSIUM ON BALTIMORE, MD, USA 22-24 APRIL 1991, NEW YORK, NY, USA,IEEE, US, 22. April 1991 (1991-04-22), Seiten 36-39, XP010044310 ISBN: 0-7803-0009-2

## Beschreibung

Die vorliegende Erfindung betrifft ein laterales Halbleiterbauelement in Dünnfilm-SOI-Technik, mit einer Isolatorschicht, die auf einem Substrat aufliegt und unterhalb eines dünnen Siliziumfilms vergraben ist, auf welchem der Source- bzw. Anoden-Kontakt und der Drain- bzw. Kathoden-Kontakt angebracht sind, gemäß dem Oberbegriff des Anspruchs 1.

Ein derartiges SOI-Halbleiterbauelement, bei welchem der Source/Anoden-Kontakt und der Drain-/Kathoden-Kontakt jeweils über räumlich voneinander getrennten Shield Gebieten, d. h. vergrabenen Übergängen innerhalb des Substrats angeordnet sind, wobei der Source-/Anoden-Kontakt mit dem Substrat elektrisch verbunden ist, wird in dem Dokument EP 0 694 977 A2 offenbart, welches den nächstliegenden Stand der Technik repräsentiert.

Aus JP 62-005662 ist ein SOI-Halbleiterbauelement bekannt, bei dem der Drain-Kontakt mit einer unter dem Isolator liegenden Zone mit einer zum Substrat gegensätzlichen Dotierung elektrisch verbunden ist.

Halbleiterbauelemente der eingangs beschriebenen Art sind schon seit längerem bekannt und werden vor allem im Niederspannungsbereich eingesetzt, z.B. als CMOS-Schaltungen. Dabei wurden bisher zumeist Schaltungen für raue Arbeitsbedingungen (hohe Temperaturen, erhöhte Teilchenstrahlung oder elektromagnetische Strahlung realisiert. Zunehmend hält die beschriebene Technologie auch in Prozessoren und in Treiberschaltungen Einzug.

Ferner kann sich bei diesen Bauelementen sowohl um Transistoren als auch um Dioden handeln. In diesem Fall sind auf dem Siliziumfilm wahlweise ein Anoden- und ein Kathoden-Kontakt oder ein Source-, ein Drain- und ein Gate-Kontakt vorgesehen. Da die Position der Anode funktionell dem Source-Kontakt eines Transistors entspricht, und die Kathode dementsprechend dem Drain-Kontakt zuzuordnen ist, werden die jeweiligen Bezeichnungen im folgenden synonym verwendet, ohne dass hierdurch eine Beschränkung der Erfindung auf ein bestimmtes Bauelement beabsichtigt wird.

Bei höheren Betriebsspannungen tritt jedoch das Problem auf, dass die Sperrfestigkeit des vergrabenen Isolators unzureichend ist und der sogenannte Back-Gate-Effekt auftritt, was bedeutet, dass eine Steuerwirkung des Substrates von unten auf das Kanalgebietdes SOI-Transistors auftritt und seine Schwellspannung verschoben wird. Dies führt dazu, dass es bei den bekannten Halbleiterbauelementen kaum möglich ist, mehrere Bauelemente mit hoher Sperrfähigkeit mittels der Dünnfilm-SOI Technologie zu realisieren.

Diese negativen Effekte lassen sich durch sehr dicke Oxidschichten minimieren oder aufheben Dieser Ansatz ist jedoch unbefriedigend, da sich beispielsweise für den Spannungsbereich von etwa 600 V die Oxide mit einem dünnen Siliziumfilm nicht mehr mit einem Aufwand realisieren lassen, der technologisch und wirtschaftlich sin voll ist. Als Alternative hierzu lässt sich ein vergrabener p-n-Übergang im Substrat erzeugen, der die gesamte Schaltung vor schädlichen Spannungen schützt, von der Unterseite der Schaltung her auftreten. Ein solcher p-n-Übergang, der z.B. durch Implantation durch den Silizumfilm und das vergrabene Oxid hindurch hergestellt werden kann, wird auch als Shield bezeichnet. Er liegt durchgehend unter der gesamten Struktur auf einem festgelegten Potential.

Durch den Shield wird die Schaltung jedoch nur vor Spannungen geschützt, die von außerhalb auf die Schaltung einwirken. Die hierdurch ermöglichten Sperrspannungen sind auch in diesem Fall relativ gering, da der Spannungsabbau durch den Siliziumfilm und den vergrabenen Isolator vorgegeben ist.

Aufgabe der vorliegenden Erfindung ist es daher, ein laterales Halbleiterbauelement der oben beschriebenen Art zu schaffen, das hohe Sperrspannungen innerhalb des Bauelements ermöglicht, gleichzeitig jedoch technologisch einfach realisierbar und wirtschaftlich herstellbar ist.

Diese Aufgabe wird erfindungsgemäß durch ein laterales Halbleiterbauelement in-Dünnfilm-SOI-Technik mit den Merkmalen des Anspruchs 1 gelöst.

Wie die bekannten lateralen Halbleiterbauelemente in Dünnfilm-SOI-Technik befinden sich auch in diesem Fall die Kontakte auf einem dünnen Siliziumfilm, unter welchem die Isolatorschicht vergraben ist. Die Anode bzw. der Sourcc- und der Gate-Kontakt eines Transistors sowie die Kathode bzw. der Drain-Kontakt liegen auf zwei unterschiedlichen und gegeneinander floatenden Shield-Gebieten. Dadurch wird die Raumladungszone nicht nur im dünnen Siliziumfilm und im vergrabenen Oxid abgebaut, sondern auch im Substrat.

Durch den elektrischen Kontakt des Anoden-Kontaktes mit dem Substrat wird die Raumladungszone auf das Substrat übertragen und damit im Siliziumfilm homogenistert.

Der Vorteil des vorliegenden Halbleiterbauelements besteht in der hohen Sperrfähigkeit seiner Struktur. Der Back-Gate-Effekt tritt nicht mehr auf, da das Shield-Gebiet strukturiert und mit der Anode jedes einzelnen Bauelements verbunden ist. Dadurch kann sich keine Back-Gate-Spannung mehr einstellen.

Die Sperrfähigkeit dieses Bauelements wird fast ausschließlich durch die tiefen p-n-Übergänge, also Shield-Ringe bestimmt, die mit einer entsprechenden Randstruktur nahezu beliebige Sperrspannungen ermöglichen. Die bei reiner p-n-Isolation auftretende Gefahr eines Latch-up besteht hier nicht mehr.

Gleichzeitig bietet die Erfindung den Vorteil, dass mehrere Hochspannungsschalter auf einem Chip integrierbar sind, ohne dass spezielle Epitaxie-Schichten, Oxiddicken des vergrabenen Isolators oder bestimmte Siliziumfilmdicken notwendig sind. Dadurch lassen sich brückenfähige Systeme auf einem Chip aufbauen und eine nahezu beliebige vertikale Transistorstruktur integrieren. Jeder Transistor kann einen dielektrisch isolierten Logik-Teil enthalten, so dass sich ganze Halb- und Vollbrückentreiber mit einer Überwachungselektronik herstellen lassen.

Damit die Spannungsfestigkeit weiter erhöht wird, werden die beiden Shield-Gebiete des Anoden- und des Kathoden-Kontaktes vorzugsweise durch eine dazwischen angeordnete vergrabene Randstruktur voneinander isoliert.

In einer bevorzugten Ausführungsform handelt es sich dabei um eine floatende Feldringstruktur. Bei solchen floatenden Feldringen, die auch als Field-Limiting-Rings (FLR) bezeichnet werden, handelt es sich um ein Randstrukturprinzip, bei dem ein sperrender p-n-Übergang durch vorgelagerte Feldringe, also p-n-Übergänge in Wannenform, geschützt wird. Diese Ringe werden nicht kontaktiert und stellen sich auf ein Potential zwischen maximaler und minimaler Spannung ein.

In weiteren bevorzugten Ausführungsformen lässt sich die vergrabene Randstruktur auch als VLE- oder als JTE-Struktur realisieren. Im Fall der VLE-Struktur (variation of laterial doping) wird ein sperrender p-n-Übergang durch einen pn-Übergang verlängert. Die dazu notwendige Dotierung nimmt in lateraler Richtung ab, wodurch eine Struktur mit immer niedrigerer Eindringtiefe und Dotierung entsteht. Im Fall einer JTE-Struktur (junction termination extension) besitzt der p-n-Übergang, der sich in lateraler Richtung anschließt, eine tiefere Eindringtiefe als der sperrende p-n-Übergang. Unter Umständen ist dazu jedoch bereits der einfache p-n-Übergang ausreichend, der zwischen dem Kathoden- und dem Anodenkontakt angeordnet ist.

Vorzugsweise ist die elektrische Verbindung des Anodenkontaktes mit dem Substrat unmittelbar durch einen metallischen Kontakt hergestellt. In einer weiteren bevorzugten Ausführungsform wird diese Verbindung durch ein elektrisches Bauelement hergestellt.

Vorzugsweise ist außer dem Anoden-Kontakt auch der Kathoden-Kontakt bzw. im Fall eines Transistors der Drain-Kontakt mit dem Substrat elektrisch kontaktiert. Entscheidend ist, dass das Shield-Gebiet kontaktiert wird, über welchem der Hauptanteil der Sperrspannung abfällt. Ist der sperrende p-n-Übergang ausreichend kontaktiert und paßt sich das SOI-Bauelement dem horizontalen Spannungsverlauf an, ist unter Umständen eine weitere Kontaktierung des SOI-Bauelements nicht erforderlich.

Ist beispielsweise das Substrat n-dotiert und der Shield ist p-dotiert, so darf die Anordnung nur mit positiven Kathoden-Anoden-Spannungen betrieben werden, wobei das höchste Potential an einem Substrat-Kontakt liegen muss, der rückseitig oder auf andere geeignete Weise angebracht ist. In diesem Fall bildet der Kathoden-Shield einen Kanalstopper, der die Struktur im Substrat abschließt und eine Ausdehnung der Raumladung über die Strukturgrenze hinaus verhindert. Der Kathoden-Shield muss in diesem Fall vom gleichen Dotierungstyp sein wie das Substrat, jedoch in Bezug auf den Anoden-Shield entgegengesetzt dotiert sein. Sind beispielsweise das Substrat n-dotiert und der Anoden-Shield p-dotiert, so muss der Kanalstopper n⁺-dotiert sein.

Vorzugsweise handelt es sich bei dem erfindungsgemäßen Halbleiterbauelement um einen Transistor, wobei der Source- und der Gate-Kontakt einerseits und der Drain-Kontakt andererseits über getrennten Shield-Gebieten innerhalb des Substrats liegen.

In weiteren bevorzugten Ausführungsformen ist das Halbleiterbauelement eine Diode, ein spannungsfester Widerstand oder ein IGBT, d.h. ein "insulated gate bipolar transistor".

In einer Halbleiterschaltung mit einem Transistor als erfindungsgemäßem Halbleiterbauelement handelt es sich dabei um einen Level-Shift-Transistor, der in eine Treiberschaltung mit einem geeigneten vertikalen Leistungsbauelement, wie etwa einem IGBT, einem DMOS oder dergleichen integriert ist.

Falls es sich bei dem erfindungsgemäßen Halbleiterbauelement um eine Diode handelt, kann diese vorzugsweise eine SOI-Diode sein und als Entkopplungsdiode, z.B. zur Strommessung, in eine Auswerteschaltung mit einem geeigneten vertikalen Leistungsbauelement, wie etwa einem IGBT, einem DMOS oder dergleichen integriert sein.

Vorzugsweise ist eine Anzahl von Transistoren und Dioden als erfindungsgemäßen Halbleiterbauelementen zu einer Brückentreiberschaltung geschaltet.

Im Folgenden wird ein bevorzugtes Ausführungsbeispiel der Erfindung anhand der beigefügten Zeichnung näher erläutert.
- Fig. 1: zeigt einen schematischen Schnitt durch ein erfindungsgemäßes laterales Halbleiterbauelement;
- Fig. 2: zeigt einen Teilschnitt des Anodenbereichs eines erfindungsgemäßen Halbleiterbauelements gemäß Fig. 1;
- Fig. 3: ist ein Schaltbild einer Schaltung mit einem erfindungsgemäßen Halbleiterbauelement als Transistor;
- Fig. 4: ist eine schematische Darstellung eines Brückenschalters aus der Schaltung in Fig. 3;
- Fig. 5: ist eine Darstellung des Brückenschalters entsprechend Fig. 4 in einem anderen Schaltungszustand;
und
- Fig. 6: zeigt den Brückenschalter aus den Figuren 4 und 5 im Sperrzustand.

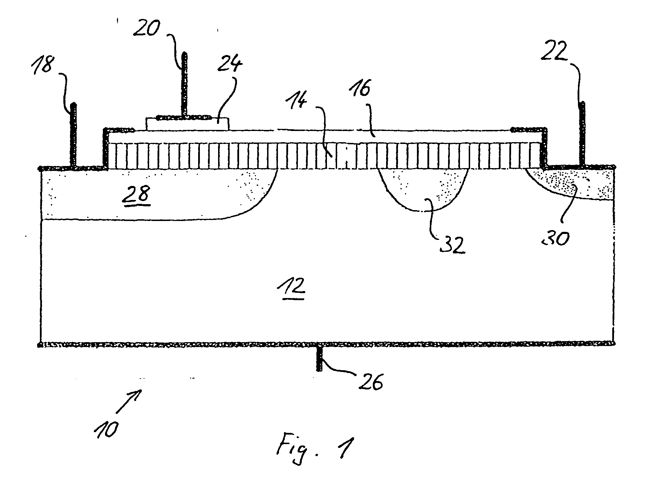

Bei dem in Fig. 1 dargestellten erfindungsgemäßen Halbleiterbauelement handelt es sich um einen Transistor 10, der in Dünnfilm-SOI-Technik hergestellt ist. Auf einem Substrat 12 liegt eine Isolatorschicht 14 auf, auf der wiederum ein Siliziumfilm 16 aufgebracht ist. Der Isolator 14 ist somit unterhalb des Siliziumfilms 16 vergraben. Auf der Oberseite des Transistors 10 sind metallische Kontakte angebracht, nämlich der Source-Kontakt 18, der Gate-Kontakt 20 und der Drain-Kontakt 22. Der Source-Kontakt 18 ist auf solche Weise angebracht, dass er einerseits mit dem Siliziumfilm 16 und andererseits gleichzeitig mit der Oberfläche des Substrats 12 kontaktiert ist. Auf die gleiche Weise ist der Drain-Kontakt 22, der an einem dem Source-Kontakt 18 gegenüberliegenden Rand des Siliziumfilms 16 angebracht ist, gleichzeitig mit dem Siliziumfilm 16 und dem Substrat 12 kontaktiert. Auf dem Siliziumfilm 16 ist in der Nähe des Source-Kontaktes 18 der Gate-Kontakt 20 angeordnet, wobei sich zwischen dem Metallkontakt 20 und der Oberfläche des Siliziumfilms 16 eine Polysilizium-Schicht 24 befindet. Ferner befindet sich an der Unterseite des Substrats 12, die dem Isolator 14 und dem Siliziumfilm 16 gegenüberliegt, ein rückseitiger Drain-Kontakt 26. Abweichend von der hier dargestellten Ausführungsform kann dieser Drain-Kontakt 26 auch an einer anderen Stelle auf der oberen Oberfläche des Substrats 12 angeordnet sein.

Innerhalb des Substrats 12 ist an dessen oberem Oberflächenbereich unterhalb des Source-Kontaktes 18 und des Gate-Kontaktes 20 ein Anoden-Shield 28 vorgesehen, also ein vergrabener p-n-Übergang. In gleicher Weise ist unterhalb des Drain-Kontaktes 22 ein Kathoden-Shield 30 vorgesehen. Zwischen dem Anoden-Shield 28 und dem Kathoden-Shield 30 befindet sich ein floatender Feldring 32 als vergrabene Randstruktur.

Die gesamte Anordnung des in Fig. 1 gezeigten Transistors 10 entspricht also einem bekannten Transistor in Dünnfilm-SOI-Technik, der sich auf einer Randstruktur 28,30,32 befindet. Der Source-Kontakt 18 und der Gate-Kontakt 20 des Tranistors 10 liegen unmittelbar oberhalb des Anoden-Gebietes 28 der Randstruktur und werden damit von störenden Feldern abgeschirmt. Hingegen liegt der Drain-Kontakt 22 an der Kathodenseite 30 der Randstruktur.

Entgegen der hier gezeigten Ausführungsform muss der Drain-Kontakt 22 nicht notwendigerweise mit dem Substrat 12 kontaktiert sein. Kontaktiert werden muss das Shield-Gebiet, über welchem der Hauptanteil der Sperrspannung abfällt. Ist der sperrende p-n-Übergang ausreichend kontaktiert und paßt sich das SOI-Bauelement dem horizontalen Spannungsverlauf an, erübrigt sich unter Umständen eine weitere Kontaktierung des SOI-Bauelements. In diesem Fall kann eine hohe Dotierung im Siliziumfilm 16 vom entgegengesetzten Dotierungs-Typ als Shield-Wanne die Eigenschaften eines Kanalstoppers übernehmen.

Ist das Substrat 12 beispielsweise n-dotiert und der Anoden-Shield 28 ist p-dotiert, darf die Transistoranordnung 10 nur mit positiven Drain-Source-Spannungen betrieben werden, wobei das höchste Potential am rückseitigen Drain-Kontakt 26 liegen muss. Sind die Dotierungen entgegengesetzt gewählt, d.h. das Substrat 12 ist p-dotiert und der Shield 28 ist n-dotiert, so sind nur negative Drain-Source-Spannungen erlaubt.

Der Spannungsabbau erfolgt über die Randstruktur, die den floatenden Feldring 32 umfasst. Der Kanalstopper 30 verhindert die Ausdehnung der Raumladung über die Grenze der Struktur hinaus und schützt gleichzeitig den Drain-Kontakt 22 vor störenden Feldern. Es ist auch möglich, anstatt des floatenden Feldrings 32 wahlweise eine VLE-Struktur oder eine JTE-Struktur als vergrabene Randstruktur zu verwenden.

Anstelle des gezeigten erfindungsgemäßen Transistors 10 lassen sich auch andere Halbleiterbauelemente, wie beispielsweise Dioden, spannungsfeste Widerstände, IGBTs u.ä. realisieren. Die Anordnung des Anoden-Kontaktes der Diode entspricht in diesem Fall der oben beschriebenen Anordnung des Source-Kontaktes 18, während der Kathoden-Kontakt dem Drain-Kontakt 22 entspricht.

Es wird ferner darauf verwiesen, dass mehrere erfindungsgemäße Bauelemente 10 auf der gleichen vergrabenen Randstruktur in Parallelschaltung realisierbar sind. Denkbar sind Schaltungen mit mehreren Transistoren, spannungsfesten Widerständen, ein Dioden-Netzwerk oder eine Kombination aus solchen Bauelementen. Möglich sind auch Reihenschaltungen, z.B. aus Transistoren und Dioden.

Das elektrische Verhalten des beschriebenen Transistors 10 als diskretes Bauelement lässt sich wie folgt beschreiben: Wird an den Drain-Kontakten 22,26 eine hohe positive Spannung angelegt und werden Source 18 und Gate 20 auf Masse gehalten, kommt es zwischen Source 18 und Drain 22 zum Aufbau einer Raumladungszone. Gegenüber vollständig isolierten SOI-Bauelementen wird diese Raumladungszone jedoch nicht nur im Siliziumfilm 16 aufgebaut, sondern mittels Kontaktierung zum Substrat 12 auch unterhalb des Siliziumfilms 16. Dies führt zu einem wesentlich homogeneren Raumladungszonenverlauf, als er sonst im relativ dünnen Siliziumfilm 16 auftritt. Eine Krümmung der Raumladungszone tritt dort kaum auf.

Die Feldlinien unterhalb der SOI-Schicht 14,16 verlaufen analog zu einer herkömmlichen Randstruktur. Die Raumladungszone wird durch die Feldringe 32 unterhalb des Siliziumfilms 16 maßgeblich beeinflusst. Je weiter sich die Raumladungszone im Substrat 12 in lateraler Richtung hin ausdehnt, desto weiter dehnt sie sich auch im Siliziumfilm 16 aus. Dadurch wird ein homogenerer Abbau der Raumladungszone im Siliziumfilm 16 ermöglicht.

Wenn die Dotierung im Siliziumfilm 16 gleich oder geringer als die des Drift-Gebietes ist, tritt der statische Avalanche-Durchbruch immer im Substrat 12 auf, wodurch eine optimale Sperrfähigkeit für den erfindungsgemäßen Transistor 10 erreicht wird. Die Sperrfähigkeit des Gesamtsystems ist dann ausschließlich vom Schichtaufbau des Substrats 12 und der Anordnung und Tiefe der Feldringe 32 oder einer anderen gewählten Randstruktur abhängig.

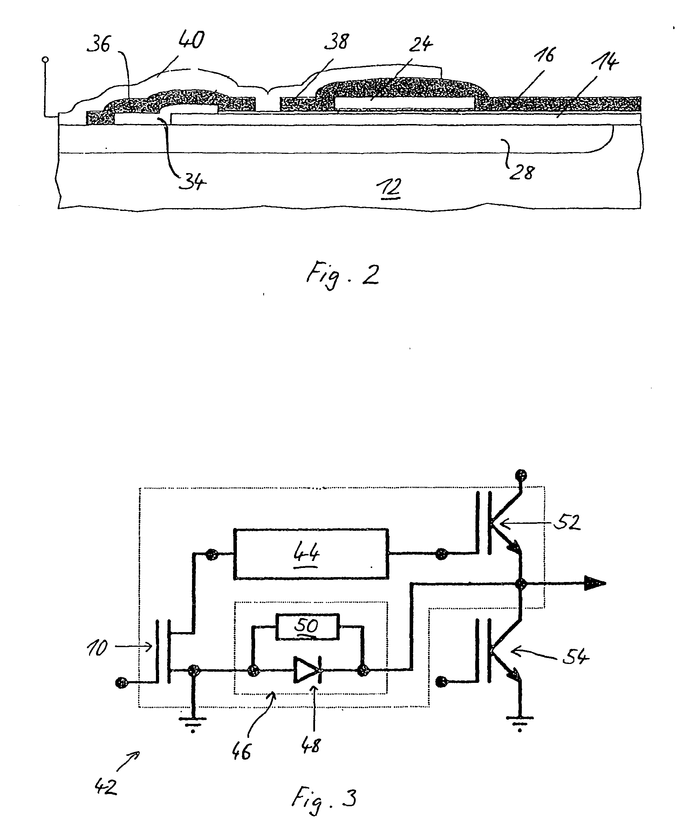

Fig. 2 zeigt eine vergrößerte Darstellung des Bereiches eines Transistors 10, in welchem sich der Anoden-Shield 28 befindet. Auf dem Oberflächenbereich des Substrats 12, in dessen Randbereich der Anoden-Shield 28 angeordnet ist, sind in bekannter Weise der Isolator 14 und die Siliziumschicht 16 übereinander aufgeschichtet. Am in Fig. 2 linken Rand der Isolatorschicht 14 ist der Source-Kontakt 18 in solcher Weise angebracht, dass eine Feldoxid-Schicht 34 einerseits auf dem Rand des vergrabenen Isolators 14 und andererseits auf dem Anoden-Shield 28 aufliegt. Die Feldoxid-Schicht 34 wird durch eine Zwischenoxid-Schicht 36 umschlossen. Der Gate-Kontakt 20 hingegen umfasst die bereits in Fig. 1 beschriebene Poly-Siliziumschicht 24, die ähnlich wie die Feldoxid-Schicht 34 durch eine Zwischenoxid-Schicht 38 bedeckt ist. Auf den Feldoxid-Schichten 36,38 ist eine Metallschicht 40 angebracht.

Anhand von Fig. 3 soll erläutert werden, in welcher Weise sich ein erfindungsgemäßer Transistor 10 in eine Schaltung integrieren lässt. Fig. 3 zeigt das Schaltbild einer Brückenschaltung 42, in die der Transistor 10 als Level-Shift-Transistor integriert ist. Die Brückenschaltung 42 umfasst ferner eine Kontrolleinheit 44, die Treiber-, Überwachungs- und Sensorfunktionen beeinhaltet und in dem Schaltbild in Fig. 3 nur schematisch dargestellt ist. Die Kontrolleinheit 44 ist an den Drain-Kontakt des Transistors 10 angeschlossen, während dessen Source-Kontakt auf Masse liegt. Bei der monolithischen Integration entsteht dabei eine parasitäre Struktur, ein sogenannter Bypass 46, die näherungsweise durch ein Ersatzschaltbild mit einer Parallelschaltung einer Diode 48 und eines Widerstands 50 beschrieben werden kann.

Die Kontrolleinheit 44 ist ihrerseits an den Gate-Kontakt eines IGBT 52 als High-Side-Schalter angeschlossen, dessen Drain-Kontakt auf der Zwischenspannung U_{ZW} liegt und dessen Source-Kontakt mit der Last kontaktiert ist. Ebenfalls an die Last angeschlossen sind der entgegengesetzte Ausgang des Bypass 50 sowie der Drain-Kontakt eines weiteren Transistors 54 als Low-Side-Schalter, dessen Source-Kontakt auf Masse liegt.

Die vorliegende Erfindung ermöglicht es, die Schaltungseinheit in Fig. 3 monolitisch auf einem Chip zu integrieren. Dadurch ergeben sich enorme Kostenvorteile und eine Platzersparnis. Gleichzeitig wird die Systemstabilität erhöht, und der Aufwand bei der Aufbau- und Verbindungstechnik wird reduziert. Ferner ergeben sich kurze Signallaufzeiten, die wiederum kurze Reaktionszeiten ermöglichen, beispielsweise im Fehlerbetrieb des Schalters.

Die Schaltinformationen für den Leistungsschalter werden mittels Pegelansteuerung des Transistors 10 an die Kontrolleinheit 44 übertragen. Um den Querstrom im Transistor 10 möglichst gering zu halten, schaltet die Kontrolleinheit 44 den IGBT 52 invers zum Hochspannungstransistor ein. Bei geschlossenem Gate des Transistors 10 schaltet der IGBT 52 ein, wobei über dem Hochvolttransistor die gesamte Zwischenkreisspannung U_{ZW} aufgebaut wird.

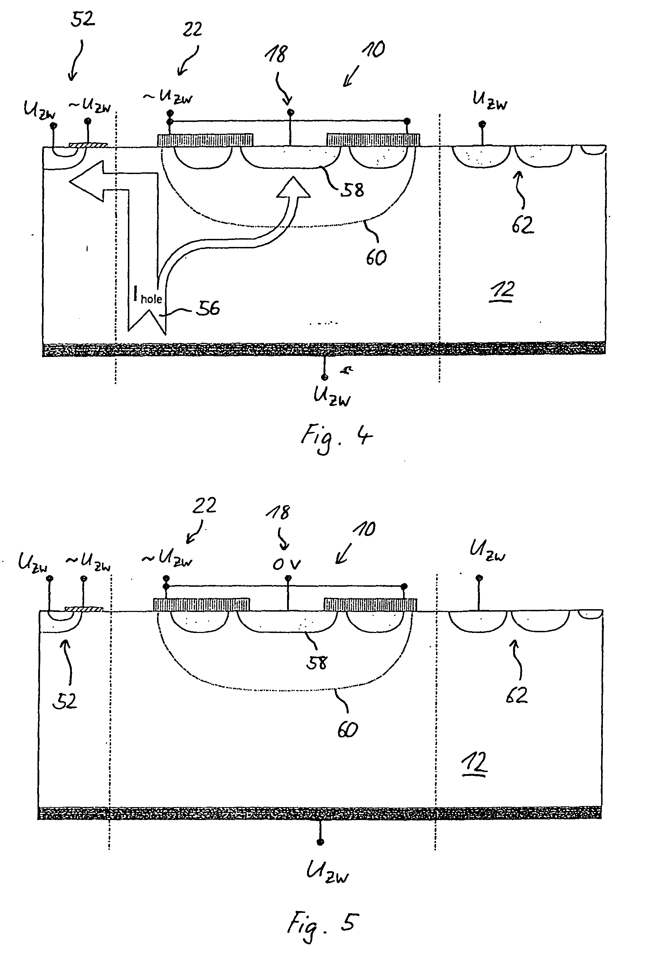

Im Folgenden soll das statische Verhalten des Transistors 10 für den Durchlassfall des IGBT 52 anhand von Fig. 4 erläutert werden. Im eingeschalteten Betrieb wird die Driftstrecke des IGBT 52 mit Ladungsträgern angereichert. Dieses sogenannte Ladungsträgerplasma entsteht durch den im IGBT-Kanal fließenden Elektronenstrom und den von diesem hervorgerufenen Löcherstrom 56, der durch Injektion am rückseitigen p-n-Übergang entsteht. Da der Löcherstrom 56 weder vom Kanal noch vom sperrenden p-n-Übergang, sondern vom Potentialverlauf im IGBT 52 beeinflusst wird, kommt es zum Stromfluss, einem sogenannten parasitären Bypass-Strom, auch in die p-Wanne 58 und damit in die Source 18 des Transistors 10. Dies macht sich als erhöhter Leckstrom am Source-Kontakt des Transistors 10, nicht aber an seinem Drain-Kontakt 22 bemerkbar. An der Bypass-Diode 48, die beide Elektroden verbindet, liegt die volle Zwischenkreisspannung U_{ZW} an. Der parasitäre Gesamtstrom am Transistor 10 setzt sich also aus dem SOI-Sperrstrom, dem Sperrstrom der Bypass-Diode 48 und dem abgesaugten, von der Rückseite kommenden Löcherstrom 56 zusammen.

Um diesen Strom möglichst klein zu halten, sollte der Transistor 10 räumlich möglichst weit vom Aktivgebiet des IGBT 52 angeordnet werden. Dadurch wird der zu überwindende Widerstand, der SOI-Bypass-Widerstand, für den Löcherstrom 56 erhöht. Auch die Koppelung des Löcherstroms 56 an den Elektrodenstrom führt zu einem geringeren Bypass-Löcherstrom.

Wird der IGBT 52 durch einen Leistungs-MOS-Transistor ausgetauscht, kann durch fehlende Rückseiteninjektion kein Löcherstrom erzeugt werden. Damit ist ein parasitärer Bypass-Strom ausgeschlossen.

Im Zusammenhang mit Fig. 5 wird der Sperrfall beschrieben. Der Drain-Kontakt und der Source-Kontakt des IGBT 52 und der Drain-Kontakt des erfindungsgemäßen Transistors 10 liegen hier auf einem hohen positiven Potential entsprechend der Zwischenkreisspannung U_{ZW}. Dies bedeutet, dass der Sperrspannungsabbau lateral und vertikal nur im Transistor 10 stattfindet. Dieser Zustand stellt den kritischsten Belastungsfall für den Hochvolttransistor dar. Die Raumladungszone bildet sich nur im Siliziumfilm 16 und im Substrat 12 im Bereich des Transistors 10 aus.

In der Brückenschaltung aus Fig. 3 trifft dieser Fall nur auf den oberen Schalter zu, wenn beide Schalter stromlos sind, der untere Schalter die Zwischenkreisspannung U_{ZW} aufnimmt und der Kommutierungsstrom durch die Freilaufdiode des oberen Schalters abfließt.

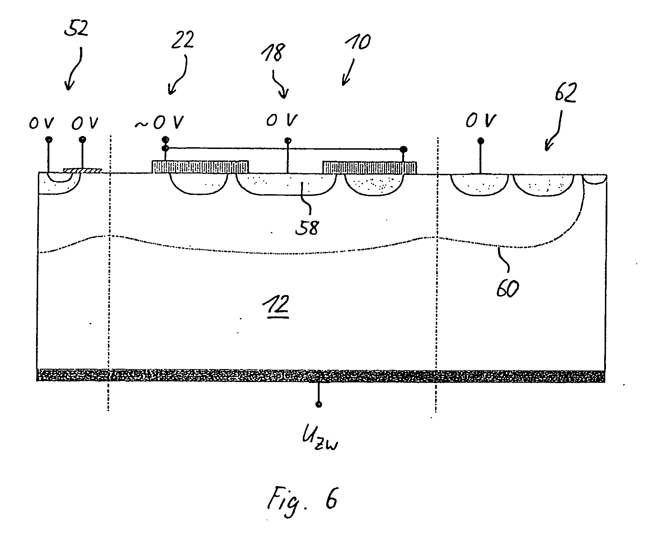

Abschließend soll anhand von Fig. 6 der Sperrfall dargestellt werden, bei welchem der Drain-Kontakt des IGBT 52 auf hohem Potential entsprechend der Zwischenkreisspannung U_{ZW} liegt, während die übrigen Elektroden etwa auf Masse liegen.

Der Abbau der Raumladungszone 60 geschieht vertikal im gesamten Chip in allen Bereichen. Lediglich an der äußeren Randstruktur 62 kommt es zum Abbau der Raumladungszone 60 auch in lateraler Richtung. In der in Fig. 3 dargestellten Brückenschaltung trifft dieser Fall auf den oberen Schalter zu, wenn der untere Schalter eingeschaltet ist. Dabei wird vom oberen Schalter die Zwischenkreisspannung U_{ZW} aufgenommen.

## Patentansprüche

1. Laterales Halbleiterbauelement (10) in Dünnfilm-SOI-Technik, mit einer Isolatorschicht (14), die auf einem Substrat (12) aufliegt und unter einem dünnen Siliziumfilm (16) vergraben ist, auf welchem der Source- bzw. Anoden-Kontakt (18) und der Drain- bzw. Kathoden-Kontakt (22) angebracht sind, wobei der Source-/Anoden-Kontakt (18) und der Drain-/Kathoden-Kontakt (22) jeweils über räumlich getrennten vergrabenen p-n-Übergängen (28,30) innerhalb des Substrats (12) liegt und der Source-/Anoden-Kontakt (18) mit dem Substrat (12) elektrisch verbunden ist, **dadurch gekennzeichnet, dass** die vergrabenen p-n-Übergänge (28,30) des Source-/Anoden- und des Drain-/Kathoden-Kontaktes (18,22) durch eine dazwischen angeordnete vergrabene Randstruktur (32) in Form eines weiteren vergrabenen sperrenden p-n-Übergangs (32) voneinander isoliert sind.

2. Laterales Halbleiterbauelement gemäß Anspruch 1, **dadurch gekennzeichnet, dass** der vergrabene sperrende p-n-Übergang (32) durch eine floatende Feldringstruktur gebildet wird.

3. Laterales Halbleiterbauelement gemäß Anspruch 1, **dadurch gekennzeichnet, dass** der vergrabene sperrende p-n-Übergang (32) durch eine "variation of laterial doping"-Struktur (VLD) gebildet wird.

4. Laterales Halbleiterbauelement gemäß Anspruch 1, **dadurch gekennzeichnet, dass** der vergrabene sperrende p-n-Übergang (32) durch eine "junction termination extension"-Struktur (JTE) gebildet wird.

5. Laterales Halbleiterbauelement gemäß einem der Ansprüche 1 bis 4, **dadurch gekennzeichnet, dass** die elektrische Verbindung des Source-/Anoden-Kontaktes (18) mit dem Substrat (12) durch einen metallischen Kontakt hergestellt ist.

6. Laterales Halbleiterbauelement gemäß einem der Ansprüche 1 bis 4, **dadurch gekennzeichnet, dass** die elektrische Verbindung des Source-/Anoden-Kontaktes (18) mit dem Substrat (12) durch ein elektrisches Bauelement hergestellt ist.

7. Laterales Halbleiterbauelement gemäß einem der vorhergehenden Ansprüche, **dadurch gekennzeichnet, dass** der Drain-/Kathoden-Kontakt (22) mit dem Substrat (12) elektrisch verbunden ist.

8. Laterales Halbleiterbauelement gemäß einem der vorhergehenden Ansprüche, **dadurch gekennzeichnet, dass** das Halbleiterbauelement (10) einen Transistor darstellt.

9. Laterales Halbleiterbauelement gemäß einem der Ansprüche 1 bis 7, **dadurch gekennzeichnet, dass** das Halbleiterbauelement (10) eine Diode darstellt.

10. Laterales Halbleiterbauelement gemäß einem der Ansprüche 1 bis 7, **dadurch gekennzeichnet, dass** das Halbleiterbauelement (10) einen spannungsfesten Widerstand darstellt.

11. Laterales Halbleiterbauelement gemäß einem der Ansprüche 1 bis 7, **dadurch gekennzeichnet, dass** das Halbleiterbauelement (10) einen IGBT darstellt.

12. Halbleiterschaltung mit einem Halbleiterbauelement gemäß Anspruch 8, **dadurch gekennzeichnet, dass** das Halbleiterbauelement (10) ein Level-Shift-Transistor ist und in eine Treiberschaltung (42) mit einem vertikalen Leistungsbauelement wie etwa einem IGBToder einem DMOS integriert ist.

13. Halbleiterschaltung mit einem Halbleiterbauelement gemäß Anspruch 9, **dadurch gekennzeichnet, dass** das Halbleiterbauelement (10) eine SOI-Diode ist und als Entkopplungsdiode in eine Auswerteschaltung mit einem vertikalen Leistungsbauelement wie etwa einem IGBT oder einem DMOS integriert ist.

14. Halbleiterschaltung mit Halbleiterbauelementen gemäß den Ansprüchen 5 und 6, **dadurch gekennzeichnet, dass** eine Anzahl von Transistoren und Dioden zu einer Brückentreiberschaltung geschaltet sind.

## Claims

1. Lateral semiconductor component (10) in thin film SOI technology, having an insulator layer (14) which is positioned on a substrate (12) and which is embedded under a thin silicon film (16), to which the source or anode contact (18) and the drain or cathode contact (22) are fitted, the source/anode contact (18) and the drain/cathode contact (22) each being located within the substrate (12) by means of spatially separated embedded p-n junctions (28, 30) and the source/anode contact (18) being electrically connected to the substrate (12), **characterised in that** the embedded p-n junctions (28, 30) of the source/anode and the drain/cathode contact (18, 22) are insulated from each other by an embedded peripheral structure (32) which is arranged therebetween and which is in the form of an additional embedded blocking p-n junction (32).

2. Lateral semiconductor component according to claim 1, **characterised in that** the embedded blocking p-n junction (32) is formed by a floating field ring structure.

3. Lateral semiconductor component according to claim 1, **characterised in that** the embedded blocking p-n junction (32) is formed by a "variation of lateral doping" structure (VLD).

4. Lateral semiconductor component according to claim 1, **characterised in that** the embedded blocking p-n junction (32) is formed by a "junction termination extension" structure (JTE).

5. Lateral semiconductor component according to any one of claims 1 to 4, **characterised in that** the electrical connection of the source/anode contact (18) with respect to the substrate (12) is produced by a metal contact.

6. Lateral semiconductor component according to any one of claims 1 to 4, **characterised in that** the electrical connection of the source/anode contact (18) with respect to the substrate (12) is produced by an electrical component.

7. Lateral semiconductor component according to any one of the preceding claims, **characterised in that** the drain/cathode contact (22) is electrically connected to the substrate (12).

8. Lateral semiconductor component according to any one of the preceding claims, **characterised in that** the semiconductor component (10) constitutes a transistor.

9. Lateral semiconductor component according to any one of claims 1 to 7, **characterised in that** the semiconductor component (10) constitutes a diode.

10. Lateral semiconductor component according to any one of claims 1 to 7, **characterised in that** the semiconductor component (10) constitutes a surge-resistant resistor.

11. Lateral semiconductor component according to any one of claims 1 to 7, **characterised in that** the semiconductor component (10) constitutes an IGBT.

12. Semiconductor circuit having a semiconductor component according to claim 8, **characterised in that** the semiconductor component (10) is a level shift transistor and is integrated in a driver circuit (42) having a vertical power component, such as, for example, an IGBT or a DMOS.

13. Semiconductor circuit having a semiconductor component according to claim 9, **characterised in that** the semiconductor component (10) is an SOI diode and is integrated, as a decoupling diode, in an evaluation circuit having a vertical power component, such as, for example, an IGBT or a DMOS.

14. Semiconductor circuit having semiconductor components according to claims 5 and 6, **characterised in that** a number of transistors and diodes are connected to form a bridge driver circuit.

## Revendications

1. Composant semi-conducteur latéral (10) SOI à couche mince, avec une couche isolante (14) qui repose sur un substrat (12) et est enfouie sous une mince pellicule de silicium (16) sur laquelle sont placés le contact source ou contact anode (18) et le contact drain ou contact cathode (22), le contact source/anode (18) et le contact drain/cathode (22) se trouvant chacun au-dessus de transitions p-n (28, 30) enfouies et séparées dans l'espace, à l'intérieur du substrat (12), et le contact source/anode (18) étant relié électriquement au substrat (12), **caractérisé en ce que** les transitions p-n (28, 30) enfouies du contact source/anode et du contact drain/cathode (18, 22) sont isolées l'une de l'autre par une structure de bordure (32) enfouie, disposée entre elles, sous la forme d'une autre transition p-n (32) de blocage, enfouie.

2. Composant semi-conducteur latéral selon la revendication 1, **caractérisé en ce que** la transition p-n (32) de blocage, enfouie, est formée par une structure annulaire de champ flottante.

3. Composant semi-conducteur latéral selon la revendication 1, **caractérisé en ce que** la transition p-n (32) de blocage, enfouie, est formée par une structure "variation of laterial doping" (VLD).

4. Composant semi-conducteur latéral selon la revendication 1, **caractérisé en ce que** la transition p-n (32) de blocage, enfouie, est formée par une structure "junction termination extension" (JTE).

5. Composant semi-conducteur latéral selon l'une des revendications 1 à 4, **caractérisé en ce que** la liaison électrique du contact source/anode (18) avec le substrat (12) est réalisée par un contact métallique.

6. Composant semi-conducteur latéral selon l'une des revendications 1 à 4, **caractérisé en ce que** la liaison électrique du contact source/anode (18) avec le substrat (12) est réalisée par un composant électrique.

7. Composant semi-conducteur latéral selon l'une des revendications précédentes, **caractérisé en ce que** le contact drain/cathode (22) est relié électriquement au substrat (12).

8. Composant semi-conducteur latéral selon l'une des revendications précédentes, **caractérisé en ce que** le composant semi-conducteur (10) constitue un transistor.

9. Composant semi-conducteur latéral selon l'une des revendications 1 à 7, **caractérisé en ce que** le composant semi-conducteur (10) constitue une diode.

10. Composant semi-conducteur latéral selon l'une des revendications 1 à 7, **caractérisé en ce que** le composant semi-conducteur (10) constitue une résistance résistant à la tension.

11. Composant semi-conducteur latéral selon l'une des revendications 1 à 7, **caractérisé en ce que** le composant semi-conducteur (10) constitue un IGBT.

12. Circuit à semi-conducteurs avec un composant semi-conducteur selon la revendication 8, **caractérisé en ce que** le composant semi-conducteur (10) est un transistor level-shift et est intégré dans un circuit d'excitation avec un composant de puissance vertical tel que par exemple un IGBT ou un DMOS.

13. Circuit à semi-conducteurs avec un composant semi-conducteur selon la revendication 9, **caractérisé en ce que** le composant semi-conducteur (10) est une diode SOI et est intégré en tant que diode de découplage dans un circuit d'évaluation avec un composant de puissance vertical tel que par exemple un IGBT ou un DMOS.

14. Circuit à semi-conducteurs avec des composants semi-conducteurs selon les revendications 5 et 6, **caractérisé en ce qu'**une pluralité de transistors et de diodes sont couplés pour former un circuit d'excitation en pont.
